# EUROPEAN PATENT APPLICATION

(11) **EP 2 079 164 A1**
(43) Date of publication of application: **15.07.2009**
(21) Application number: 08172220.9
(22) Date of filing: 18.12.2008
(51) Int. Cl.: H03K 5/003, H02H 9/04

(54) **Semiconductor device**

(30) Priority: 08.01.2008 JP 2008001506
(71) Applicant: Mitsumi Electric Co., Ltd., Tama-shi, Tokyo 206-8567 (JP)
(72) Inventor: Yamaguchi, Koichi, Tokyo 206-8567 (JP); Kawagoe, Osamu, Tokyo 206-8567 (JP)
(74) Representative: Rees, Alexander Ellison

(57) **Abstract**

A disclosed semiconductor device includes a first power terminal to which a high voltage is applied; a clamping circuit electrically connected to the first power terminal; and an internal circuit electrically connected to the clamping circuit and driven by a voltage lower than the high voltage. The clamping circuit includes a bipolar transistor. The emitter of the bipolar transistor is electrically connected to the first power terminal. The collector of the bipolar transistor is grounded. The base of the bipolar transistor is electrically connected to the collector of the bipolar transistor.

## Description

### BACKGROUND OF THE INVENTION

### 1. Field of the Invention

The present invention herein is directed to a semiconductor device.

### 2. Description of the Related Art

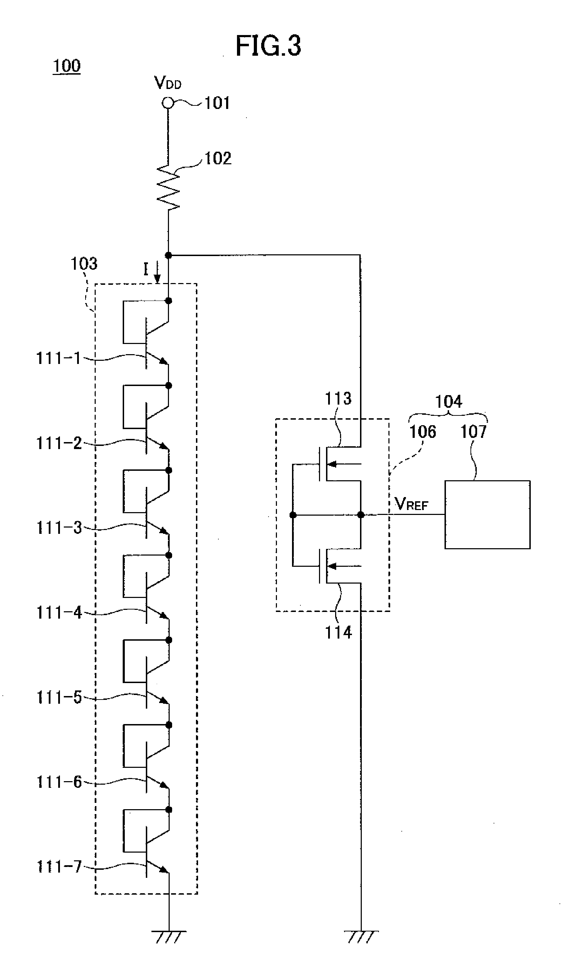

Some conventional semiconductor devices have a high-voltage circuit and a low-voltage circuit loaded together. In such a semiconductor device, a clamping circuit is provided to prevent high voltages from being applied to the low-voltage circuit (an internal circuit 104 of FIG. 3) (see FIG. 3).

FIG. 3 is a circuit diagram of a conventional semiconductor device.

With reference to FIG. 3, a conventional semiconductor device 100 includes a power terminal 101 to which a high voltage V_{DD} (e.g. 30 V) is applied, a resistor 102, a clamping circuit 103 and the internal circuit 104 driven by a low voltage (e.g. 5 to 6 V).

The power terminal 101 is electrically connected to the clamping circuit 103 via the resistor 102. The high voltage V_{DD} is applied to the power terminal 101. The resistor 102 is provided to control the current flowing to the clamping circuit 103.

The clamping circuit 103 includes multiple NPN bipolar transistors (seven transistors in the case of FIG. 3) 111-1 through 111-7 connected in series. The collector of the NPN bipolar transistor 111-1 disposed closest to the resistor 102 is electrically connected to the power terminal 101 via the resistor 102. The emitter of the NPN bipolar transistor 111-7 most distant from the resistor 102 is grounded. The base and collector of each NPN bipolar transistor 111-1 to 111-7 are electrically connected to each other. Each NPN bipolar transistor 111-1 to 111-6 is electrically connected to the collector and the base of the adjacent NPN bipolar transistor 111-2 to 111-7, respectively.

The NPN bipolar transistors 111-1 through 111-7 described above respectively function as forward diodes each diode including a base (P) and an emitter (N)). The clamping circuit 103 having such a structure achieves voltage clamping by the use of base-emitter voltages V_{BE} of the NPN bipolar transistors 111-1 through 111-7 (i.e. the sum of voltages arising due to a current I flowing through the NPN bipolar transistors 111-1 through 111-7). Herewith, it is possible to prevent a high voltage from being applied to the internal circuit 104, thereby protecting the internal circuit 104 from being damaged.

The internal circuit 104 includes a reference voltage generating circuit 106 and a low-voltage driven circuit 107. The reference voltage generating circuit 106 includes N-MOS transistors 113 and 114. The drain of the N-MOS transistor 113 is electrically connected to the clamping circuit 103. The source of the N-MOS transistor 114 is grounded. The gate of the N-MOS transistor 113 is electrically connected to the gate of the N-MOS transistor 114. In addition, the gates of the N-MOS transistors 113 and 114 are electrically connected to the source of the N-MOS transistor 113, the drain of the N-MOS transistor 114 and the low-voltage driven circuit 107.

The reference voltage generating circuit 106 having the above-described structure is provided to generate a reference voltage V_{REF} which is lower than the high voltage V_{DD} applied to the power terminal 101. The low-voltage driven circuit 107 is driven when the reference voltage V_{REF} is applied.

Patent Document 1 below is an example of patent literature that discloses a structure similar to that of the conventional semiconductor device 100 described above. Specifically, the structures illustrated in FIGs. 4 and 5 of Patent Document 1 are similar to the structure of the conventional semiconductor device 100. FIGs. 4 and 5 of Patent Document 1 disclose structures that divide a reference voltage generated by a reference voltage generating circuit.
Patent Document 1: Japanese Laid-open Patent Application Publication No. S62-49422

As for the conventional semiconductor device 100, however, the base-emitter voltage V_{BE} of each NPN bipolar transistor 111-1 through 111-7 functioning as a forward direction diode is small (e.g. 0.7 V), and accordingly, it is necessary to configure the clamping circuit 103 using multiple (seven in the case of FIG. 3) NPN bipolar transistors 111-1 through 111-7. As a result, the clamping circuit 103 requires a large space in the plane of the semiconductor device 100, and it is thus difficult to reduce the size of the semiconductor device 100.

### SUMMARY OF THE INVENTION

In view of the above-mentioned problem, the present invention aims at providing a semiconductor device allowing miniaturization by reducing the size of the clamping circuit in the plane of the semiconductor device.

One aspect of the present invention may be to provide a semiconductor device including a first power terminal to which a high voltage is applied; a clamping circuit electrically connected to the first power terminal; and an internal circuit electrically connected to the clamping circuit and driven by a voltage lower than the high voltage. The clamping circuit includes a bipolar transistor. The emitter of the bipolar transistor is electrically connected to the first power terminal. The collector of the bipolar transistor is grounded. The base of the bipolar transistor is electrically connected to the collector of the bipolar transistor.

### BRIEF DESCRIPTION OF THE DRAWINGS

FIG. 1 is a circuit diagram of a semiconductor device according to a first embodiment of the present invention;
FIG. 2 is a circuit diagram of a semiconductor device according to a second embodiment of the present invention; and
FIG. 3 is a circuit diagram of a conventional semiconductor device.

### DETAILED DESCRIPTION OF THE PREFERED EMBODIMENTS

Next are described embodiments of the present invention with reference to the drawings.

### First Embodiment

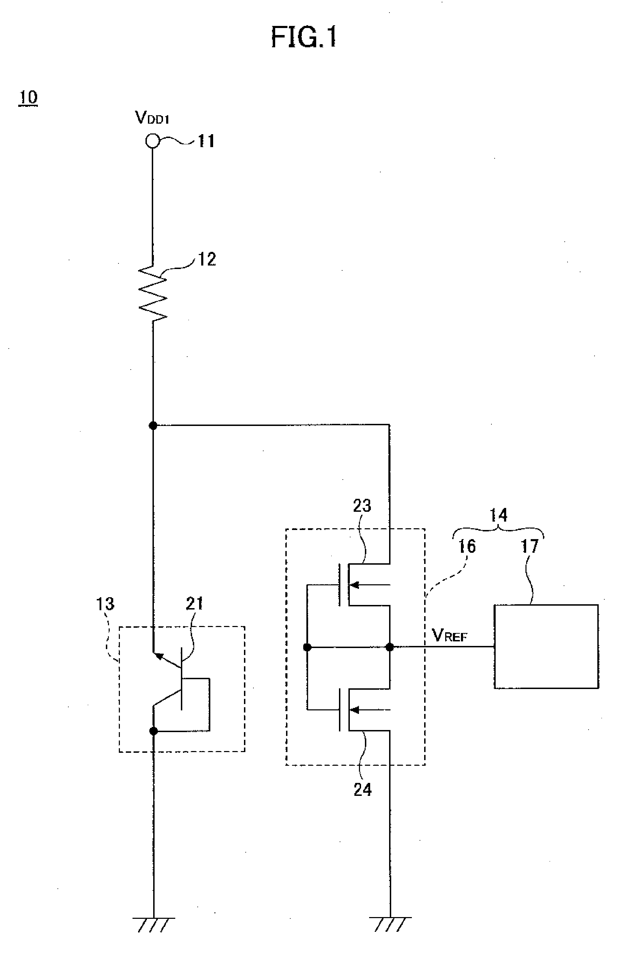

FIG. 1 is a circuit diagram of a semiconductor device according to the first embodiment of the present invention.

With reference to FIG. 1, a semiconductor device 10 of the first embodiment includes a power terminal 11 which is a first power terminal, a resistor 12, a clamping circuit 13 and an internal circuit 14 driven by a low voltage.

A high voltage V_{DD1} (e.g. 30V) is applied to the power terminal 11. The power terminal 11 is electrically connected to the clamping circuit 13 via the resistor 12. The resistor 12 is electrically connected to the power terminal 11 and the clamping circuit 13.

The clamping circuit 13 includes a single NPN bipolar transistor 21. The emitter of the NPN bipolar transistor 21 is electrically connected to the power terminal 11 via the resistor 12, and also electrically connected to the internal circuit 14. The collector of the NPN bipolar transistor 21 is grounded. The base and collector of the NPN bipolar transistor 21 are electrically connected to each other. The clamping circuit 13 having the above-described structure is provided to prevent high voltages that could damage the internal circuit 14 from being applied to the internal circuit 14.

According to the above-described structure, voltage clamping can be achieved by the use of a reverse voltage (e.g. 6 V) across the NPN bipolar transistor 21, which is larger than the base-emitter voltage (e.g. 0.7 V) of the NPN bipolar transistor 21 when connected in the forward direction. This allows the clamping circuit 13 to be configured with only one bipolar transistor 21. As a result, the size of the clamping circuit 13 in the plane of the semiconductor device 10 can be reduced, thereby allowing miniaturization of the semiconductor device 10 (specifically, miniaturization of the semiconductor device 10 in the plane direction).

The internal circuit 14 includes a reference voltage generating circuit 16 and a low-voltage driven circuit 17 which is driven by a low voltage (e.g. 5 to 6 V). The reference voltage generating circuit 16 is electrically connected to the low-voltage driven circuit 17. The reference voltage generating circuit 16 includes N-MOS transistors 23 and 24. The drain of the N-MOS transistor 23 is electrically connected to the emitter of the NPN bipolar transistor 21. The source of the N-MOS transistor 24 is grounded. The gate of the N-MOS transistor 23 is electrically connected to the gate of the N-MOS transistor 24. In addition, the gates of the N-MOS transistors 23 and 24 are electrically connected to the source of the N-MOS transistor 23 and the drain of the N-MOS transistor 24.

The reference voltage generating circuit 16 having the above-described structure is provided to generate the reference voltage V_{REF} which is lower than the high voltage V_{DD1} applied to the power terminal 11. The low-voltage driven circuit 17 is driven when the reference voltage V_{REF} is applied.

The present embodiment is characterized in that the clamping circuit 13 includes a single NPN bipolar transistor 21; the emitter of the NPN bipolar transistor 21 is electrically connected to the power terminal 11; the collector of the NPN bipolar transistor 21 is grounded; and the base and collector of the NPN bipolar transistor 21 are electrically connected to each other. Herewith, it is possible to achieve voltage clamping by the use of the reverse voltage (e.g. 6V) across the NPN bipolar transistor 21 (which is larger than the base-emitter voltages of the NPN bipolar transistor 21 when connected in the forward direction). This allows the clamping circuit 13 to be configured with only one NPN bipolar transistor 21. As a result, the size of the clamping circuit 13 in the plane of the semiconductor device 10 can be reduced, thereby allowing miniaturization of the semiconductor device 10 (specifically, miniaturization of the semiconductor device 10 in the plane direction).

### Second Embodiment

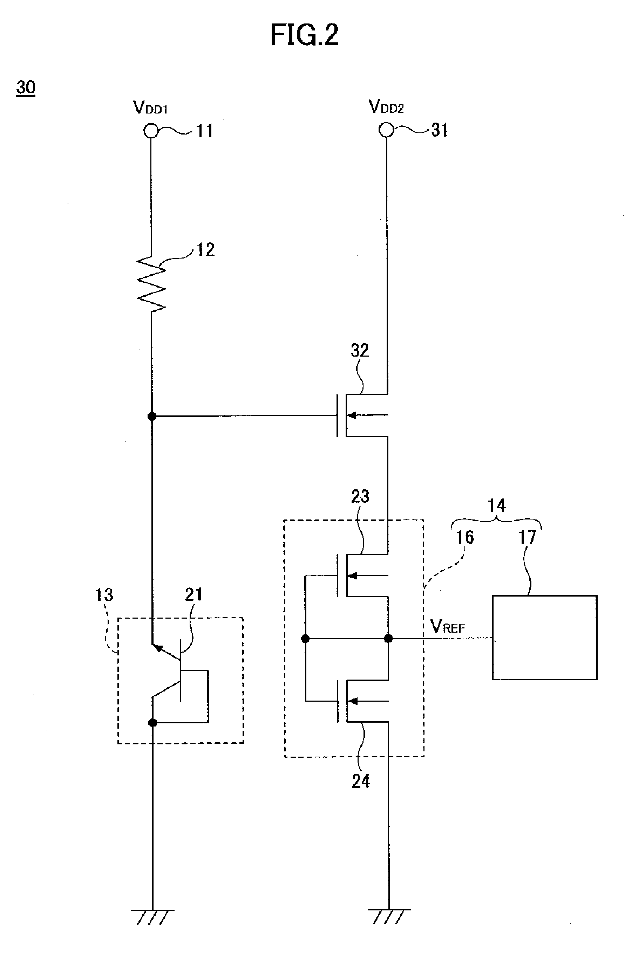

FIG. 2 is a circuit diagram of a semiconductor device according to the second embodiment of the present invention. In FIG. 2, the same reference numerals are given to the components which are common to the semiconductor device 10 of the first embodiment.

With reference to FIG. 2, a semiconductor device 30 of the second embodiment differs from the semiconductor device 10 of the first embodiment in that it further includes a power terminal 31 which is a second power terminal, and a high voltage MOS transistor 32. The remaining structure is the same as in the first embodiment.

A high voltage V_{DD2} (e.g. 30V) is applied to the power terminal 31. The power terminal 31 is electrically connected to the high-voltage MOS transistor 32.

The base of the high-voltage MOS transistor 32 is electrically connected to the emitter of the NPN bipolar transistor 21. The drain of the high-voltage MOS transistor 32 is electrically connected to the power terminal 31. The source of the high-voltage MOS transistor 32 is electrically connected to the drain of the N-MOS transistor 23.

Thus, by providing the two power terminals 11 and 31 and the high-voltage MOS transistor 32 electrically connected to the power terminal 31, the clamping circuit 13 and the internal circuit 14, a larger amount of current can be supplied to the internal circuit 14 compared to the case of the semiconductor device 10 of the first embodiment. Thus, a circuit consuming a large amount of current can be employed as the internal circuit 14.

The semiconductor device of the present embodiment is characterized by providing the power terminal 31 to which a high voltage is applied and the high-voltage MOS transistor 32 electrically connected to the power terminal 31, and electrically connecting the internal circuit 14 and the bipolar transistor 13 via the high-voltage MOS transistor 32. This allows a large amount of current to be supplied to the internal circuit 14, and thus a circuit consuming a large amount of current can be employed as the internal circuit 14.

Note that the semiconductor device 30 of the present embodiment achieves the same effect as the semiconductor device 10 of the first embodiment.

The present invention is applicable to a semiconductor device that includes a clamping circuit electrically connected to a power terminal to which a high voltage is applied and an internal circuit electrically connected to the clamping circuit and driven by a low voltage.

Although the invention has been described with respect to specific embodiments for a complete and clear disclosure, the appended claims are not to be thus limited but are to be construed as embodying all modifications and alternative constructions that may occur to one skilled in the art that fairly fall within the basic teachings herein set forth.

This patent application is based on Japanese Priority Patent Application No. 2008-001506 filed on January 8, 2008, the entire contents of which are hereby incorporated herein by reference.

## Claims

1. A semiconductor device comprising:
a first power terminal to which a high voltage is applied;
a clamping circuit electrically connected to the first power terminal; and
an internal circuit electrically connected to the clamping circuit and driven by a voltage lower than the high voltage;
wherein the clamping circuit includes a bipolar transistor,
an emitter of the bipolar transistor is electrically connected to the first power terminal,
a collector of the bipolar transistor is grounded, and
a base of the bipolar transistor is electrically connected to the collector.

2. The semiconductor device as claimed in claim 1, further comprising:
a second power terminal to which another high voltage is applied; and
a high-voltage MOS transistor electrically connected to the second power terminal;
wherein the internal circuit and the bipolar transistor are electrically connected to each other via the high-voltage MOS transistor.

3. The semiconductor device as claimed in claim 1, wherein the internal circuit includes: a reference voltage generating circuit electrically connected to the bipolar transistor and configured to generate the voltage lower than the high voltage; and a low-voltage driven circuit electrically connected to the reference voltage generating circuit.

4. The semiconductor device as claimed in claim 2, wherein the internal circuit includes: a reference voltage generating circuit electrically connected to the bipolar transistor and configured to generate the voltage lower than the high voltage; and a low-voltage driven circuit electrically connected to the reference voltage generating circuit.
